# FASCICULE DE BREVET EUROPEEN

(11) **EP 2 954 335 B1**
(45) Date de publication et mention de la délivrance du brevet: **12.04.2017**
(21) Numéro de dépôt: 14708600.3
(22) Date de dépôt: 31.01.2014
(51) Int. Cl.: G01R 19/25, H02J 7/04

(54) **MÉTHODE DE DÉTERMINATION DE LA VALEUR MOYENNE D'UN SIGNAL DE TENSION PÉRIODIQUE OU QUASI-PÉRIODIQUE**
VERFAHREN ZUR BESTIMMUNG DES DURCHSCHNITTSWERTES EINES PERIODISCHEN ODER QUASIPERIODISCHEN SPANNUNGSSIGNALS
METHOD FOR DETERMINING THE AVERAGE VALUE OF A PERIODIC OR QUASI-PERIODIC VOLTAGE SIGNAL

(30) Priorité: 07.02.2013 FR 1351056
(43) Date de publication de la demande: 16.12.2015
(73) Titulaire: Renault S.A.S., 92100 Boulogne-Billancourt (FR)
(72) Inventeur: MOUVET, Matthieu, F-78000 Versailles (FR); COURTEMANCHE, Florian, F-78000 Versailles (FR)
(86) Numéro de dépôt international: PCT/FR2014/050180
(87) Numéro de publication internationale: WO 2014/122384

(56) Documents cités:
- EP-A2- 0 128 492
- DE-C1- 19 613 736
- US-A- 4 418 310
- US-A- 5 578 917

## Description

La présente invention concerne une méthode de détermination de la valeur moyenne d'un signal de tension périodique ou quasi-périodique.

Elle s'applique notamment, mais non exclusivement, à la détermination de la valeur moyenne d'un signal de tension d'une cellule de batterie dans le cadre de la gestion de la charge des batteries haute tension équipant les véhicules automobiles électriques ou hybrides, pour l'alimentation d'un moteur électrique d'entraînement de ces véhicules. Ce type de batterie comporte classiquement une pluralité d'accumulateurs électriques, ou cellules, incluant un système électrochimique rechargeable destiné à fournir une tension nominale.

De manière à assurer la recharge de ces batteries haute tension, il est connu, par exemple, de fournir un chargeur intégré au véhicule électrique, du type comprenant un convertisseur-contrôleur de puissance, apte à délivrer une puissance de charge aux cellules de la batterie, directement à partir d'un réseau d'alimentation monophasé ou triphasé auquel il est connecté. Lors de la charge d'une batterie avec certains chargeurs, le courant de charge peut présenter en sortie du chargeur une ondulation périodique ou quasi-périodique résiduelle (communément appelé « ripple » de courant, selon la terminologie anglo-saxonne), due à une suppression incomplète de la composante alternative du signal au sein du chargeur. Cette composante alternative résiduelle du courant de charge présente une fréquence de base multiple de la fréquence porteuse du réseau électrique duquel le courant de charge est dérivé et crée lors de la charge, au niveau des cellules de la batterie, une ondulation de tension proportionnelle, qui s'avère être gênante pour déterminer avec précision la valeur de la tension moyenne aux bornes des cellules de la batterie.

Or, la connaissance de la tension moyenne aux bornes des cellules d'une batterie est une information nécessaire au bon fonctionnement du système de contrôle de la batterie (dit BMS, pour « Battery Management System », selon la terminologie anglo-saxonne), qui est l'organe ayant pour rôle de contrôler les paramètres de chaque cellule de la batterie en fonction de mesures effectuées par différents capteurs, tels que des capteurs de courant, de tension et de température, de manière à maintenir la batterie dans un état de fonctionnement optimal, eu égard notamment aux contraintes de fonctionnement du véhicule électrique. En particulier, la connaissance de la tension moyenne aux bornes des cellules de la batterie permet au BMS de réguler les puissances disponibles en charge et en décharge, de connaître l'état de charge de la batterie, de réguler la fin de charge ou encore de préserver l'intégrité de la batterie par rapport aux éventuelles surtensions au niveau des cellules.

Les limites des solutions classiques de mesure de la tension aux bornes des cellules de la batterie lors de la charge, eu égard aux fluctuations de tension générées par le ripple du courant de charge, tiennent au fait que la fréquence des mesures est faible par rapport à la fréquence des fluctuations de tensions (sous-échantillonnage) et cette fréquence est en outre imposée par d'autres contraintes du système. Dans ce cas, la tension vue par le système est soit « gelée » sur une valeur fixe correspondant à la tension moyenne aux bornes des cellules, plus ou moins l'amplitude de la fluctuation, soit fluctuante dans ce même intervalle.

On connaît du document de brevet US 4,418,310, un dispositif pour contrôler un chargeur de batterie pour véhicule électrique en réponse à un état de charge réel de la batterie, ledit dispositif permettant de surveiller la tension réelle aux bornes des cellules de la batterie en tant qu'indicateur de l'état de charge de la batterie, afin de déconnecter automatiquement le chargeur de la batterie et ainsi arrêter la charge, pour éviter les surtensions aux bornes de la batterie. Pour ce faire, le dispositif de contrôle comprend notamment des moyens pour calculer une tension moyenne aux bornes des cellules de la batterie prises sur une période de temps prédéterminée. Selon ce document, cette période de temps prédéterminée pour le moyennage est choisie suffisamment longue, par exemple supérieure à une minute, de manière à éliminer, ou du moins à limiter, toutes incidences parasites sur la grandeur calculée, liées aux variations momentanées de la tension de sortie du chargeur, au « ripple » de courant, ainsi qu'à d'autres bruits de ligne. Cependant, outre le risque de mesures « gelées » comme évoqué plus haut, la solution de mesure de la tension moyenne aux bornes des cellules d'une batterie préconisée par ce document, repose sur des périodes de moyennage trop longue, qui sont incompatibles avec les contraintes du système, qui nécessitent notamment l'envoi au BMS de la moyenne calculée à intervalles réguliers rapprochés, typiquement toutes les 100 ms.

Dans ce contexte, un but de l'invention est de proposer une méthode de détermination de la valeur moyenne d'un signal de tension périodique ou quasi-périodique ou quasi périodique, notamment d'un signal de tension aux bornes des cellules d'une batterie haute tension pour véhicule électrique lors de la charge, qui soit exempte des limitations énoncées précédemment et, en particulier, qui permette de procurer un niveau de performance satisfaisant dans un contexte de sous-échantillonnage du signal imposé par des contraintes du système liés à l'émission de cette valeur moyenne périodiquement sur un bus de communication.

A cette fin, l'invention concerne une méthode de détermination de la valeur moyenne d'un signal de tension périodique ou quasi-périodique destinée à être émise sur un bus de communication avec une période d'émission supérieure à la période dudit signal, dans laquelle on acquiert des mesures dudit signal avec une période de mesure correspondant à la période d'émission de ladite valeur moyenne sur le bus, et on obtient ladite valeur moyenne à partir desdites mesures acquises, ladite méthode étant caractérisée en ce qu'elle comprend des étapes de :
- application (S2), pour chaque mesure, d'un délai variable, définissant un instant de réalisation (Tᵢ) de la mesure au sein de ladite période de mesure par rapport à un instant de référence,
- obtention (S6) de ladite valeur moyenne à partir du résultat de la mesure opérée à chaque instant de réalisation (Tᵢ) et des résultats des mesures effectuées précédemment.

Cette stratégie de détermination de la valeur moyenne, basée sur l'application lors de chaque mesure d'un délai variable, avant l'exécution de la mesure proprement dite, est avantageusement beaucoup moins exigeante sur les composants électroniques et donc beaucoup moins chère, comparée aux solutions d'obtention de la valeur moyenne par réalisation d'un échantillonnage rapide.

Selon d'autres caractéristiques avantageuses de la méthode conforme à l'invention, prises isolément ou en combinaison :
- ledit délai variable appliqué pour chaque mesure suit une séquence de délais variables consistant préférentiellement en une séquence prédéterminée de délais dans laquelle les délais varient sur au moins deux valeurs de délai distinctes prédéterminées ;
- en variante, ledit délai variable appliqué pour chaque mesure peut être déterminé de manière aléatoire ;
- ladite méthode comprend une étape d'émission sur ledit bus de communication avec ladite période d'émission de ladite valeur moyenne ainsi obtenue ;
- ladite étape d'obtention de la valeur moyenne peut inclure de calculer une moyenne pondérée du résultat de mesure courant avec la dernière valeur de tension moyenne obtenue ;
- ladite étape d'obtention de la valeur moyenne peut en variante inclure de calculer une moyenne pondérée du résultat de mesure courant avec certains résultats de mesure précédents.
- ladite méthode s'applique avantageusement à la détermination de la valeur moyenne d'un signal de tension d'une cellule de batterie haute tension d'un véhicule automobile électrique ou hybride, au cours de l'application d'un mode de charge de ladite batterie, dans lequel le courant de charge fourni au moyen d'un chargeur présente une fluctuation périodique ou quasi-périodique, ladite méthode étant désactivée dans des modes d'utilisation de ladite batterie autres que ledit mode de charge ;
- ladite méthode peut comprendre une étape de sélection de ladite séquence de délais variables en fonction des fréquences potentielles desdites fluctuations du courant de charge fourni par ledit chargeur ;
- ladite méthode peut comprendre une étape de sélection de ladite séquence de délais variables en fonction de ladite période de mesure et/ou du nombre de mesures pour l'obtention de ladite valeur moyenne et/ou de la précision requise pour ladite valeur moyenne ;
- ladite méthode peut comprendre une étape préalable d'estimation de la variation de la précision de ladite valeur moyenne en fonction de séquences prédéterminées de délais variables aptes à être appliquées et une étape de sélection de ladite séquence prédéterminée de délais à appliquer propre à maximiser la précision.

D'autres caractéristiques et avantages de l'invention ressortiront clairement de la description qui en est faite ci-après, à titre indicatif et nullement limitatif, en référence aux dessins annexés, dans lesquels:
- la Figure 1 est un logigramme représentant les principales étapes prises en compte lors du déroulement de la méthode de détermination de la tension moyenne conforme à l'invention ;
- La figure 2 est un chronogramme représentant l'évolution temporelle du processus de mesure conduisant à la détermination de la tension moyenne, selon un mode de réalisation particulier.

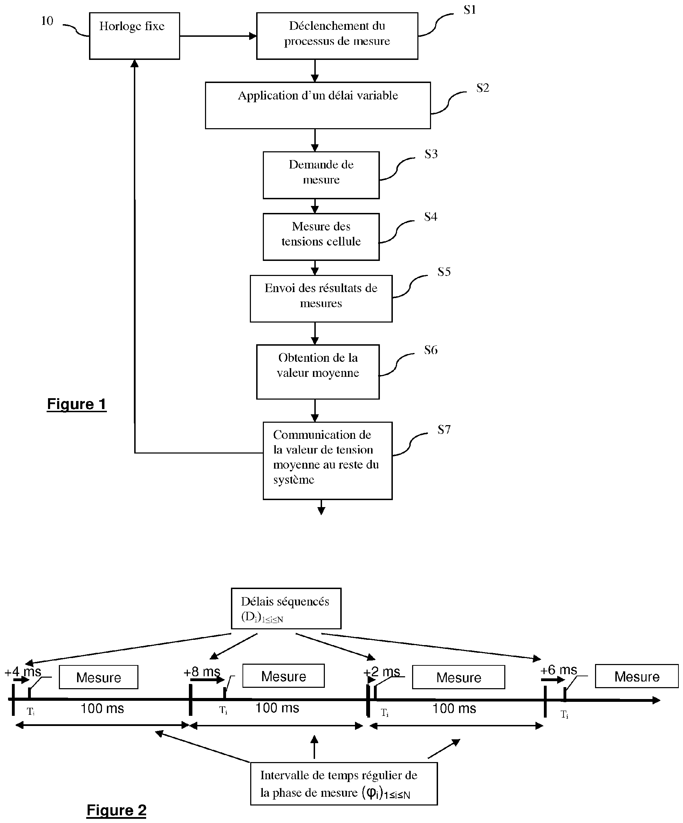

Les opérations réalisées au sein du système de contrôle de la batterie sont réalisées à intervalle de temps régulier, fixé par une horloge 10 du système, comme illustrée à la figure 1. En particulier, l'horloge 10 du système de contrôle de la batterie est conçue, dans une étape S1, pour déclencher un processus de mesure, dans laquelle des composants de mesure sont agencés pour acquérir des mesures de l'ensemble des tensions aux bornes des cellules de la batterie avec une période de mesure fixée par l'horloge 10, en réponse à une demande de mesure envoyée par un organe de contrôle des composants de mesure. La période de mesure fixée répond à différentes contraintes du système de contrôle de batterie, et correspond à la période P_{c} selon laquelle la valeur de tension moyenne découlant de la mesure réalisée par les composants de mesure doit être envoyée sur un bus de communication du système pour être rendue disponible au système, cette période d'émission Pc sur le bus de communication étant supérieure à la période du signal de tension que l'on cherche à mesurer. La fréquence d'acquisition des mesures est ainsi calée sur la fréquence d'émission sur le bus de communication.

Les fonctions des composants de mesure sont par exemple implémentées sous forme matérielle par un dispositif ou un composant dédié, tel qu'un ASIC (Application-Specific Integrated Circuit en anglais ou Circuit Intégré Spécifique à une Application en français).

Conformément à l'invention, dans une étape S2, lors de chaque phase de mesure mise en oeuvre pour l'acquisition d'une mesure du signal de tension aux bornes des cellules de la batterie avec la période de mesure P_{c} fixée par l'horloge 10, un délai variable est appliqué avant l'envoi, dans une étape S3, de la demande de mesure aux composants de mesure. Ainsi, pour chacune de N phases de mesure successives (ϕᵢ)_{1≤i≤N}, N correspondant au nombre de mesures sur lesquelles la moyenne sera réalisée, il est prévu d'appliquer un délai variable (Dᵢ)_{1≤i≤N}, définissant un instant de réalisation Tᵢ de la mesure au sein de la période de mesure, de sorte qu'une mesure est réalisée à chaque instant Tᵢ = T₀ + i x P_{c} + Dᵢ, pour 1≤i≤N et T₀ un instant de référence correspondant au déclenchement du processus de mesure.

Avantageusement, le délai variable appliqué pour chaque phase de mesure suit une séquence prédéterminée de délais dans laquelle les délais varient sur au moins deux valeurs de délai distinctes prédéterminées.

Les délais appliqués suivent donc préférentiellement une séquence prédéterminée de délais variables, qui est sélectionnée en fonction de plusieurs paramètres, pris seuls ou en combinaison, parmi lesquels la période de mesure fixée par l'horloge 10, le nombre de mesures sur lesquelles la moyenne sera réalisée, des fréquences potentielles des fluctuations de courant (ripple de courant) du chargeur lors de la charge de la batterie, et la précision requise pour la détermination de la tension moyenne.

Afin d'opérer la sélection de la séquence prédéterminée de délais la plus appropriée à la détermination d'une valeur moyenne cohérente de la tension des cellules de la batterie, on peut mettre en oeuvre une étape préalable d'estimation de la variation de la précision de la tension moyenne obtenue en fonction de séquences prédéterminées de délais variables susceptibles d'être appliquées, puis on sélectionne la séquence prédéterminée de délais à appliquer, de manière à maximiser la précision.

Alternativement, lors de l'étape S2, plutôt que d'appliquer un délai suivant une séquence prédéterminée de délais, on applique un délai déterminé de manière aléatoire lors de chaque phase de mesure avant l'envoi de la demande de mesure aux composants de mesure.

La figure 2 illustre la chronologie d'une séquence prédéterminée de délais dans le cas particulier d'un système de contrôle de batterie imposant une période de mesure égale à 100 ms, sur un système de charge potentiellement soumis à des fluctuations de courant de 100 Hz à 120 Hz. La séquence prédéterminée de délais suivante [+0; +4; +8; +2; +6] ms comme illustré à la figure 2 est un exemple de séquence de délais donnant un bon niveau de performance, avec la réalisation ultérieure d'un lissage réalisé par la moyenne algébrique des 5 dernières valeurs de mesure, comme il sera expliqué plus loin.

L'application, lors de chaque phase de mesure, d'un délai suivant une séquence prédéterminée de délais variables permet en effet de modifier séquentiellement la durée entre chaque mesure réalisée par les composants de mesure et modifie ainsi la distribution des différents instants de mesure au sein de chaque phase de mesure successives mise en oeuvre pour l'obtention de la moyenne. Le signal de tension qu'on cherche à moyenner étant un signal plus ou moins périodique, cette distribution rendue différente des instants de mesure au sein de la période de mesure fixée pour chaque phase de mesure successive permet avantageusement d'obtenir une moyenne cohérente sur l'ensemble des résultats de mesure.

A nouveau en référence à la figure 1, à chaque phase de mesure, après l'expiration du délai appliqué suivant la séquence prédéterminée de délais ou, alternativement, appliqué aléatoirement, la demande de mesure est envoyée à l'étape S3 par l'organe de contrôle aux composants de mesure, qui réalisent donc, dans une étape S4, la mesure de l'ensemble des tensions aux bornes des cellules de la batterie à chaque instant de mesure Tᵢ défini au sein de la période de mesure en fonction du délai variable appliqué. Dans une étape S5, à chaque instant de mesure Tᵢ, les résultats de la mesure obtenus sont alors renvoyés à l'organe de contrôle, automatiquement ou sur demande de celui-ci, et sont stockés en mémoire. A partir du résultat de mesure courant et des résultats précédents stockés en mémoire, une étape S6 d'obtention de la valeur moyenne de la tension est mise en oeuvre, fournissant la valeur moyenne de la tension aux bornes des cellules de la batterie. Cette moyenne peut par exemple être algébrique, ou peut aussi être obtenue en utilisant des coefficients de pondération, ou bien encore au moyen de toute autre méthode connue de lissage de résultats. Préférentiellement, le résultat de mesure courant peut être moyenné avec la dernière valeur de tension moyenne déterminée. La tension moyenne ainsi obtenue est ensuite rendue disponible au reste du système dans une étape S7, de sorte que la tension moyenne est périodiquement émise sur le bus de communication du système avec une période d'émission égale à 100 ms selon l'exemple de la figure 2.

La stratégie de détermination de la tension moyenne aux bornes des cellules de la batterie qui vient d'être décrite en référence aux étapes décrites à la figure 1 et qui repose essentiellement sur l'application, avant l'envoi de la demande de mesure pour chaque phase de mesure mise en oeuvre, d'un délai variable suivant une séquence de délais prédéterminée ou, alternativement, déterminé aléatoirement, puis sur un lissage des résultats de mesure obtenus, est préférentiellement activée uniquement pendant un mode de charge des cellules de la batterie et est désactivée dans les modes d'utilisation de la batterie autres que le mode de charge, par exemple en mode de roulage. En effet, une dynamique plus rapide peut être nécessaire hors du mode de charge de la batterie, par exemple en mode de roulage du véhicule. Ainsi, la désactivation de la stratégie de détermination de la tension moyenne aux bornes des cellules de la batterie conforme à l'invention en fonction du mode, permet avantageusement de conserver cette dynamique.

De plus, une chronologie avec une séquence de délais connus, par exemple des délais compris entre 0 et 10 ms, et un temps de réalisation des mesures connu, compris typiquement entre 5 et 30 ms, permet avantageusement de conserver un temps de réserve fixe et régulier lors de chaque phase de mesure, utilisable pour les autres opérations à réaliser par le système, comme la réalisation de diagnostiques, l'équilibrage des cellules, la mesure des températures, etc.

## Revendications

1. Méthode de détermination de la valeur moyenne d'un signal de tension périodique ou quasi-périodique dans laquelle ladite valeur moyenne est émise sur un bus de communication avec une période d'émission supérieure à la période dudit signal et dans laquelle on acquiert des mesures dudit signal avec une période de mesure correspondant à la période d'émission de ladite valeur moyenne sur le bus, et on obtient ladite valeur moyenne à partir desdites mesures acquises, ladite méthode étant **caractérisée en ce qu'**elle comprend des étapes de :
- application (S2), pour chaque mesure, d'un délai variable, définissant un instant de réalisation (Tᵢ) de la mesure au sein de ladite période de mesure par rapport à un instant de référence,
- obtention (S6) de ladite valeur moyenne à partir du résultat de la mesure opérée audit instant de réalisation (Tᵢ) et des résultats des mesures effectuées précédemment.

2. Méthode selon la revendication 1, **caractérisée en ce que** ledit délai variable appliqué pour chaque mesure suit une séquence de délais variables ((Dᵢ)_{1≤i≤N}) consistant en une séquence prédéterminée de délais dans laquelle les délais varient sur au moins deux valeurs de délai distinctes prédéterminées.

3. Méthode selon la revendication 1, **caractérisée en ce que** ledit délai variable appliqué pour chaque mesure est déterminé de manière aléatoire.

4. Méthode selon l'une quelconque des revendications précédentes, **caractérisée en ce qu'**elle comprend une étape d'émission (S7) sur ledit bus de communication avec ladite période d'émission de ladite valeur moyenne ainsi obtenue.

5. Méthode selon l'une quelconque des revendications précédentes, **caractérisée en ce que** ladite étape d'obtention de la valeur moyenne (S6) inclut de calculer une moyenne pondérée du résultat de mesure courant avec la dernière valeur de tension moyenne obtenue.

6. Méthode selon l'une quelconque des revendications 1 à 4, **caractérisée en ce que** ladite étape d'obtention de la valeur moyenne (S6) inclut de calculer une moyenne pondérée du résultat de mesure courant avec certains résultats de mesure précédents.

7. Méthode selon l'une quelconque des revendications précédentes, **caractérisée en ce qu'**elle s'applique à la détermination de la valeur moyenne d'un signal de tension d'une cellule de batterie haute tension d'un véhicule automobile électrique ou hybride, au cours de l'application d'un mode de charge de ladite batterie, dans lequel le courant de charge fourni au moyen d'un chargeur présente une fluctuation périodique ou quasi-périodique, ladite méthode étant désactivée dans des modes d'utilisation de ladite batterie autres que ledit mode de charge.

8. Méthode selon les revendications 7 et 2, **caractérisée en ce qu'**elle comprend une étape de sélection de ladite séquence de délais variables en fonction des fréquences potentielles desdites fluctuations du courant de charge fourni par ledit chargeur.

9. Méthode selon la revendication 2, **caractérisée en ce qu'**elle comprend une étape de sélection de ladite séquence de délais variables en fonction de ladite période de mesure et/ou du nombre de mesures pour l'obtention de ladite valeur moyenne et/ou de la précision requise pour ladite valeur moyenne.

10. Méthode selon la revendication 2, **caractérisée en ce qu'**elle comprend une étape préalable d'estimation de la variation de la précision de ladite valeur moyenne en fonction de séquences prédéterminées de délais variables aptes à être appliquées et une étape de sélection de ladite séquence prédéterminée de délais à appliquer propre à maximiser la précision.

## Patentansprüche

1. Verfahren zur Bestimmung des Durchschnittswerts eines periodischen oder quasiperiodischen Spannungssignals, wobei der Durchschnittswert auf einem Kommunikationsbus mit einer Sendeperiode, die größer als die Periode des Signals ist, ausgegeben wird, und wobei Messungen des Signals mit einer Messperiode erfasst werden, die der Sendeperiode des Durchschnittswerts auf dem Bus entsprechen, und der Durchschnittswert aus den erfassten Messungen erhalten wird, wobei das Verfahren **dadurch gekennzeichnet ist, dass** es Schritte aufweist:
- des Anwendens (S2) für jede Messung einer variablen Verzögerung, die einen Zeitpunkt der Durchführung (Tᵢ) der Messung innerhalb der Messperiode in Bezug auf einen Bezugszeitpunkt definiert,
- des Erhaltens (S6) des Durchschnittswerts ausgehend von dem Ergebnis der durchgeführten Messung zu dem Zeitpunkt der Durchführung (Tᵢ) und der Ergebnisse der zuvor durchgeführten Messungen.

2. Verfahren nach Anspruch 1, **dadurch gekennzeichnet, dass** die variable Verzögerung, die für jede Messung angewendet wird, einer Sequenz von variablen Verzögerungen ((Dᵢ)_{1≤i≤N}) folgt, die aus einer vorbestimmten Sequenz von Verzögerungen besteht, in der die Verzögerungen an mindestens zwei verschiedenen vorbestimmten Verzögerungswerten variieren.

3. Verfahren nach Anspruch 1, **dadurch gekennzeichnet, dass** die variable Verzögerung, die für jede Messung angewendet wird, zufällig bestimmt wird.

4. Verfahren nach einem der vorhergehenden Ansprüche, **dadurch gekennzeichnet, dass** es einen Schritt des Sendens (S7) des auf diese Weise erhaltenen Durchschnittswerts auf dem Kommunikationsbus mit der Sendeperiode aufweist.

5. Verfahren nach einem der vorhergehenden Ansprüche, **dadurch gekennzeichnet, dass** der Schritt des Erhaltens des Durchschnittswerts (S6) ein Berechnen eines gewichteten Durchschnitts des aktuellen Messergebnisses mit dem letzten erhaltenen Durchschnittsspannungswert enthält.

6. Verfahren nach einem der Ansprüche 1 bis 4, **dadurch gekennzeichnet, dass** der Schritt des Erhaltens des Durchschnittswerts (S6) ein Berechnen eines gewichteten Durchschnitts des aktuellen Messergebnisses mit gewissen vorhergehenden Messergebnissen enthält.

7. Verfahren nach einem der vorhergehenden Ansprüche, **dadurch gekennzeichnet, dass** es auf die Bestimmung des Durchschnittswerts eines Spannungssignals einer Hochspannungsbatteriezelle eines Elektro-oder Hybridkraftfahrzeugs während der Anwendung eines Lademodus der Batterie angewendet wird, wobei der Ladestrom, der mit einem Ladegerät bereitgestellt wird, eine periodische oder quasiperiodische Schwankung aufweist, wobei das Verfahren in den anderen Verwendungsmodi der Batterie als dem Lademodus deaktiviert wird.

8. Verfahren nach einem der Ansprüche 7 und 2, **dadurch gekennzeichnet, dass** es einen Schritt des Auswählens der Sequenz von variablen Verzögerungen in Abhängigkeit von den potenziellen Frequenzen der Schwankungen des Ladestroms, der von dem Ladegerät bereitgestellt wird, aufweist.

9. Verfahren nach Anspruch 2, **dadurch gekennzeichnet, dass** es einen Schritt des Auswählens der Sequenz von variablen Verzögerungen in Abhängigkeit von der Messperiode und/oder der Anzahl an Messungen zum Erhalten des Durchschnittswerts und/oder der erforderlichen Genauigkeit für den Durchschnittswert aufweist.

10. Verfahren nach Anspruch 2, **dadurch gekennzeichnet, dass** es einen vorhergehenden Schritt des Schätzens der Variation der Genauigkeit des Durchschnittswerts in Abhängigkeit von vorbestimmten Sequenzen von variablen Verzögerungen, die geeignet sind, angewendet zu werden, und einen Schritt des Auswählens der vorbestimmten Sequenz von anzuwendenden Verzögerungen, die geeignet ist, die Genauigkeit zu maximieren, aufweist.

## Claims

1. Method for determining the average value of a periodic or quasi-periodic voltage signal in which said average value is transmitted on a communication bus with a transmission period greater than the period of said signal and in which measurements of said signal are acquired with a measurement period corresponding to the transmission period of said average value on the bus, and said average value is obtained from said acquired measurements, said method being **characterized in that** it includes steps of:
- applying (S2), for each measurement, a variable delay, defining a measurement instant (Tᵢ) within said measurement period with respect to a reference instant,
- obtaining (S6) said average value from the result of the measurement carried out at said measurement instant (Tᵢ) and from the results of the measurements made previously.

2. Method according to Claim 1, **characterized in that** said variable delay applied for each measurement follows a sequence of variable delays ((Dᵢ)_{1≤i≤N}) consisting of a predetermined sequence of delays in which the delays vary over at least two predetermined separate delay values.

3. Method according to Claim 1, **characterized in that** said variable delay applied for each measurement is determined randomly.

4. Method according to any one of the preceding claims, **characterized in that** it includes a step of transmitting (S7) on said communication bus with said transmission period said average value thus obtained.

5. Method according to any one of the preceding claims, **characterized in that** said step of obtaining the average value (S6) includes calculating a weighted average of the current measurement result with the latest average voltage value obtained.

6. Method according to any one of Claims 1 to 4, **characterized in that** said step of obtaining the average value (S6) includes calculating a weighted average of the current measurement result with some previous measurement results.

7. Method according to any one of the preceding claims, **characterized in that** it applies to determining the average value of a voltage signal of a high voltage battery cell of an electric or hybrid motor vehicle, during the application of a charge mode of said battery, in which the charge current supplied by means of a charger presents a periodic or quasi-periodic fluctuation, said method being deactivated in usage modes of said battery other than said charge mode.

8. Method according to Claims 7 and 2, **characterized in that** it includes a step of selecting said sequence of variable delays according to the potential frequencies of said fluctuations of the charge current supplied by said charger.

9. Method according to Claim 2, **characterized in that** it includes a step of selecting said sequence of variable delays according to said measurement period and/or the number of measurements for obtaining said average value and/or the accuracy required for said average value.

10. Method according to Claim 2, **characterized in that** it includes a preliminary step of estimating the variation in accuracy of said average value according to predetermined sequences of variable delays capable of being applied and a step of selecting said predetermined sequence of delays to be applied appropriate to maximizing the accuracy.
